Europäisches Patentamt

European Patent Office

Office européen des brevets

(11) Publication number: **0 028 719**
**B1**

(12) **EUROPEAN PATENT SPECIFICATION**

(45) Date of publication of patent specification: **30.05.84**

(51) Int. Cl.³: **G 01 R 1/073, G 01 L 1/16**

(21) Application number: **80106255.5**

(22) Date of filing: **15.10.80**

(54) **Probe assembly for testing integrated circuits.**

(30) Priority: **05.11.79 US 90956**

(43) Date of publication of application:
**20.05.81 Bulletin 81/20**

(45) Publication of the grant of the patent:
**30.05.84 Bulletin 84/22**

(84) Designated Contracting States:
**DE FR GB**

(56) References cited:
**GB-A-2 014 315**
**GB-A-2 014 743**
**US-A-3 001 031**
**US-A-3 247 404**

(73) Proprietor: **TEXAS INSTRUMENTS
INCORPORATED**
**13500 North Central Expressway**
**Dallas Texas 75265 (US)**

(72) Inventor: **Reid, Lee R.**
**Rt. 1, Box 80**
**Plano, Texas (US)**

(74) Representative: **Leiser, Gottfried, Dipl.-Ing. et al**
**Patentanwälte Prinz, Bunke & Partner**
**Ernsberger Strasse 19**
**D-8000 München 60 (DE)**

Courier Press, Leamington Spa, England.

## Description

The invention relates to a probe assembly as defined in the preamble of claim 1.

Probe assemblies of this type are described in GB—A—2 014 315 and GB—A—2 014 743.

According to these prior proposals, a small thin piezoelectric member was affixed to a larger mounting member to which also there was attached a probe tip. In operation, an electrical signal was produced by the piezoelectric member when sufficient force was imparted to the probe tip to cause flexing of the mounting member and corresponding flexing of the piezoelectric member.

While the foregoing proposal constituted substantial improvements in the prior art, greatly contributing to reliability and accuracy of testing and markedly reducing damage to the work pieces by the probes, there nevertheless continued to be sought a simplified construction which would offer manufacturing economies and improved reliability including reduction in maintenance.

In US—A—3 001 034 a phonograph tone arm assembly is described having an arm made of piezoelectric material. This arm carries a rigid stylus having a record engaging tip thereon. In this arrangement a fully analog deflection sensing is required which must be highly linear over a reasonable range. No provisions whatsoever are made for separate signal and data paths and nothing is suggested to achieve isolation of the data path from an additional signal path.

Accordingly, it is one general object of this invention to improve probe assemblies. It is another object of this invention to simplify construction of such probe assemblies.

It is another object of this invention to decrease maintenance and increase reliability of such probe assemblies.

In accordance with the invention these objects are achieved by a probe assembly as defined in claim 1. In the probe assembly according to the invention the necessity for a composite structure is eliminated.

Additional features of the invention are defined in the dependent claims 2 to 7. In accordance with one additional feature the electrically conductive path includes deposited metal, thereby simplifying manufacture. According to further additional features the probe assembly includes two additional electrical connections comprising a pair of deposited metal areas located on opposite surfaces of said support body and transversely interposed between said path to probe tip and said pair of voltage sensing connections. This additional metallization which may be grounded effectively electrically isolates appropriate portions of the support body and prevents unwanted internal electrical coupling.

These and other objects and features of the invention will be apparent from the following detailed description, by way of example, with reference to the drawing in which:

Figure 1 is a side view of a preferred embodiment of the invention;

Figure 2 is an end view of the embodiment of Figure 1; and

Figure 3 is a side view similar to that of Figure 1 except for an additional optional metallization which may be employed to enhance electrical isolation.

Background of the invention

To more fully appreciate the invention, it may be helpful to review the background thereof.

In the formation of electronic circuits, integrated circuits may be fabricated from thin semiconductor slices having a plurality of matrices or micro circuits thereon. Customarily, each slice contains a multiple of identical repeating matrices of the same type of micro circuits. The individual unit or circuit is sometimes referred to as an integrated circuit chip or an individual bar.

Before final processing and encapsulation, it is customary to test each of the circuits on an overall integrated circuit chip on a slice or a wafer prior to separating the slice into the desired components or combinations thereof.

Since each micro circuit or integrated circuit of each wafer is normally positioned in a predetermined precise relation with respect to adjacent circuit units, it is possible to test the circuitry if a probe can be accurately located on each preselected point that corresponds to the circuit to be tested. It is thus possible, for example, to test several different circuits at the same time on any one integrated circuit portion.

In the test procedure, there are several obstables to overcome in order to have reliable testing without damaging the slice. One of the difficulties experienced in the use of testing probes which include a supporting body having a needle connected thereto, is that the point of the probe tip may form a scratch on the surface of the semiconductor wafer as it is contacted by the point. This is caused by the lack of an effective z-axis control. As will be evident to those skilled in the art, the z-axis is the direction established by the vertical movement of the chuck with respect to the probe tips. Among other things, the z-axis control is needed to compensate for the surface warpage of slices which may as much as 125 $\mu$m across the entire surface of a large slice, determining the point of contact with the wafer and determining when the probe tips are off the slice, i.e., edge detection.

Semiconductor slice testing is performed on a multiprobe machine such as that manufactured by Electroglass Corporation of Menlo Park, California, e.g., Model 1034X. The multiprobe machine contains a probe card which is a printed circuit board having attached thereto a series of data probes for injecting signals and collecting test data from the semiconductor slice. The practice according to the prior art includes an edge sensor on the probe card which is in the form of a data probe having an electrical switch mechanism. Operationally, the conventional edge sensor functions such that when the probe tip makes contact with the silicon slice, an electrical open is caused. This open is detected by the multiprobe system and allows for a continuance of the testing procedures. When the chuck or support block for the semiconductor slice is vertically moved to make contact with the probe tips and no contact is detected by the edge sensor, the open condition will not occur and the multiprobe system will perform an indexing procedure and move the slice such that the data probes are over the next row of integrated circuit chips. This conventional edge sensor has been found to be unreliable in the art and the cause of significant amount of downtime of the multiprobe system and damage to chips which results when the chuck is continuously moved upward and probe tip contact is not identified. After the probe tips make contact with the slice, it is necessary for the chuck to yet move an additional 50 to 125 $\mu$m of over travel in order to break through the oxide layer and make good electrical contact with the active circuit elements, a technique called scrub-in. If the probe contact with the slice is not identified, the over travel cannot be controlled and the result is probe tip breakage, excessive over travel, which damages chips and in addition, machine downtime.

To overcome the foregoing deficiencies, adjustable mounting members were included. On the mounting members were disposed the contact-making tips and in addition a separate small region of piezoelectric material. In operation, when the probe tips made contact with the work piece, a small yet effective force was imparted thereto and this was in turn imparted to the mounting member. A minute deflection of the mounting member resulted in the corresponding deflection of the piezoelectric material attached thereto, whereupon a very small yet detectable voltage was developed by the piezoelectric material, and this voltage was conducted to detecting circuits which sensed the existence of such voltage and were used to position the chuck accordingly. While these proposals were effective and constituted a marked advancement in the probe testing equipment of the prior art, there nevertheless continued to be a need for increased simplification, reduced cost of manufacture, enhanced reliability and low maintenance.

Detailed description of the invention

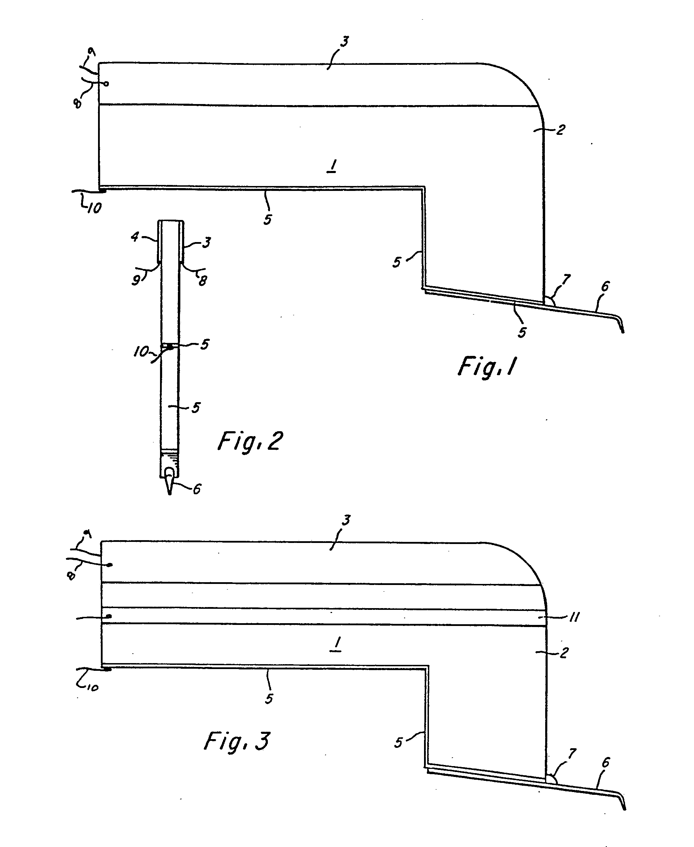

Reference to Figure 1 reveals a probe assembly 1 comprising a generally L-shaped member 2 comprised of piezoelectric material such as zirconate-lead titanate (PZT). In accordance with a preferred embodiment, the L-shaped member was made with a thickness of approximately 0,5 mm, an overall height of approximately 7 mm and an overall width of approximately 14 mm. The vertical dimension of the tail of the L was approximately 3,8 mm, the width of the downwardly extending portion was approximately 3,8 mm, and the lower surface of the downwardly extending portion was inclined at an angle of about 7° from the horizontal. However, it should be evident to those skilled in the art, that such dimensions will vary markedly, depending upon the particular equipment with which the tip probe is used, and that other dimensions may be more optimally related to such other equipment.

The probe itself is further connected to a probe card or printed circuit board along with a plurality of similar probes for testing the semiconductor slices. A z-axis signal generated by the piezoelectric material is recognized by the sensing circuits of the multiprobe system to indicate that the detector has made contact with the surface of the semiconductor slice allows the multiprobe system to move a chuck support a fixed additional distance in the z-axis direction to insure total data probe contact and proper scrub-in.

In accordance with the preferred embodiment of the present invention, the entire L-shaped member is made of piezoelectric material, and advantage is taken of the fact that when the material is normally in a quiescent state it exhibits very high electrical resistance and consequently acts as an excellent insulating mounting member itself on which other coacting portions may be affixed.

On L-shaped member 2, there are disposed three electrical conductors 3, 4 and 5. These are preferably deposited layers of suitable materials such as silver or electroless nickel. Because of the high resistance qualities of the piezoelectric material, these metallized areas are effectively insulated from each other through the main member 2.

The probe tip 6 is conductively attached to the thin metalized region 5 which lies along the bottom surface of the downward extending portion of member 2 by any suitable means such as soldering. The needle itself is made of any suitable resilient conductive material and is conventional to those skilled in the art.

Also shown in Figure 1 is an optional reinforcing region 7 which provides additional support and connective strength between the needle 6 and the main member 2. This additional connective material may be any suitable substance such as epoxy.

As mentioned above, the entire assembly may be coated with a suitable protective coating such as epoxy.

Further reference to the Figures reveals electrical connections 8, 9 and 10 individually made to the metalized regions 3, 4 and 5. Connection 10 is made to the conventional circuits of the aforementioned tester which supplies and

obtains from the chip electrical quantities that are analyzed by the testing equipment to determine the operability of the integrated circuit.

Connections 8 and 9 are those which convey the electrical signal developed by the piezoelectric material itself to utilization circuits (not shown) which sense the presence of the signal and control travel of the z-axis chuck.

Further, the probe assembly 1 is connected to the probe card or printed circuit board of the aforementioned test equipment, along with a plurality of similar probes which are used for testing the semiconductor slice and the z-axis signal received by the utilization circuits indicating that the detector probe has made contact with the surface of the semiconductor slice conditions the multiprobe system to move the chuck support a fixed distance in the z-axis thereafter to insure total data probe contact and proper scrub-in.

The test needle 6 which contacts the semiconductor slice therefore performs two functions. First of all, through the force that it imparts to the piezoelectric material directly, it results in the development of the aforementioned piezoelectric voltage which is conducted via leads 8 and 9 to the utilization circuits. Thereafter, when the chuck has traveled the additional 50 to 125 $\mu$m, electrical contact is made by the tip of the needle with an appropriate location on an underlying integrated circuit and electrical quantities are conducted thereto and therefrom via the needle itself, metallization 5 and electrical conductor 10.

In accordance with the invention herein, voltages in the range of approximately 350 millivolts have been produced at output terminals 8 and 9 in response to contact of the probe tip with a semiconductor wafer. As will be recognized by those skilled in the art, such voltage is amply sufficient to permit detection thereof and utilization in conventional circuits.

An alternative structure is depicted in Figure 3. There it will be observed that there is included an additional metallization 11 which occurs on both sides of the member 2 in corresponding locations. In embodiments where vertical geometries are exceedingly small and where, accordingly, there might be come capacitive or other coupling between the voltages existing or imparted to metallization 5 and those developed in the principal piezoelectric detecting metallizations 3 and 4, the guard layers 11 may be advantageously employed. When grounded, guard layers 11 tend to reduce or eliminate any coupling of electrical potentials between the aforementioned portions.

It will now be evident to those skilled in the art, that although the description hereof illustrates the invention in specific embodiments, other materials and dimensions could readily be employed without departing from the scope and spirit thereof. For example, layers 3 and 4 might be both positioned on the same, rather than opposite, sides of the main member 2.

## Claims

1. A probe assembly for testing integrated circuits comprising a body (2) of piezoelectric material, an electrically conductive probe tip (6) mechanically connected to said body (2) and responsive to the application of force thereto equal to or greater than a predetermined level to impart to said piezoelectric material a piezoelectric voltage producing force, means (5) attached to said body (2) providing an electrically conductive path to and from said electrically conductive probe tip (6) for making external electrical connection to said probe tip (6) and a first pair of electrical connections (3, 4) at spaced regions on said body of piezoelectric material for sensing voltage produced by said piezoelectric material in response to said voltage producing force, characterized in that said body (2) of piezoelectric material acts as the support member of said probe assembly by supporting said probe tip (6).

2. A probe according to claim 1 in which said body (2) is of substantially L-shaped profile.

3. A probe according to claim 1 in which said means providing an electrically conductive path (5) includes deposited metal.

4. A probe according to claim 3, in which said means providing an electrically conductive path (5) also includes a discrete wire.

5. A probe according to claim 1 in which said first pair of electrical connections (3, 4) at spaced regions comprises a first pair of deposited metal areas located on opposite surfaces of said body (2).

6. A probe according to claim 1 further including a second pair of electrical connections (11) comprising a second pair of deposited metal areas located on opposite surfaces of said body (2) and interposed between said means providing an electrically conductive path (5) and said first pair of voltage sensing connections (3, 4).

7. A probe according to claim 1, in which said probe tip (6) is resilient and protrudes beyond said body (2).

## Patentansprüche

1. Sondenanordnung zum Testen integrierter Schaltungen mit einem Körper (2) aus piezoelektrischem Material, einer mechanisch mit dem Körper (2) elektrisch verbundenen leitenden Sondenspitze (6), die auf das Anlegen einer Kraft, die gleich oder größer als ein vorbestimmter Wert ist, so anspricht, daß auf das piezoelektrische Material eine eine piezoelektrische Spannung erzeugende Kraft ausgeübt wird, an dem Körper (2) befestigte Mittel (5), die einen elektrisch leitenden Weg zu und von der elektrisch leitenden Sondenspitze (6) für die Herstellung einer externen elektrischen Verbindung zu der Sondenspitze (2) bilden, und ein erstes Paar elektrischer Anschlüsse (3, 4) an im Abstand voneinander liegenden Zonen an dem Körper aus piezoelektrischen Material zum Abgreifen einer von dem piezoelektrischen Material als Reaktion auf die spannungserzeugende Kraft erzeugten Spannung, dadurch gekennzeichnet, daß der Körper (2) aus piezoelektrischem Material als Trägerteil für die Sondenanordnung wirkt, indem es die Sondenspitze (6) trägt.

2. Sonde nach Anspruch 1, bei der der Köper (2) ein im wesentlichen L-förmiges Profil hat.

3. Sonde nach Anspruch 1, bei der die Mittel, die einem elektrisch leitenden Weg (5) bilden, durch Abscheidung aufgebrachtes Metall enthalten.

4. Sonde nach Anspruch 3, bei der die Mittel, die einen elektrisch leitenden Weg (5) bilden, auch einen diskreten Draht enthalten.

5. Sonde nach Anspruch 1, bei der das erste Paar elektrischer Anschlüsse (3, 4) an im Abstand voneinander liegenden Zonen ein erstes Paar durch Abscheidung aufgebrachter Metallbereiche enthält, die an gegenüberliegenden Oberflächen des Körpers (2) angebracht sind.

6. Sonde nach Anspruch 1 mit einem zweiten Paar elektrischer Anschlüsse (11), die ein zweites Paar durch Abscheidung aufgebrachter Metallbereiche enthalten, die auf gegenüberliegenden Oberflächen des Körpers (2) und zwischen den einen elektrisch leitenden Weg (5) bildenden Mitteln und dem ersten Paar der Spannungsabtastanschlüsse (3, 4) angebracht sind.

7. Sonde nach Anspruch 1, bei der die Sondenspitze (6) federnd ist und über den Körper (2) vorsteht.

**Revendications**

1. Une structure de sonde pour le test de circuits intégrés comprenant un corps (2) en matière piézoélectrique, une pointe de sonde conductrice de l'électricité (6) accouplée mécanaquement au corps (2) et réagissant à l-application à elle-même d'une force égale ou supérieure à un niveau prédétermine en communiquant à la matière piézoélectrique une force produisant une tension piézoélectrique, des moyens (5) fixés au corps (2), établissant un chemin conducteur de l'électricité vers la pointe de sonde conductrice de l'électricité (6) et à partir d'elle, pour établir une connexion électrique externe avec la pointe de sonde (6) et une première paire de connexions électriques (3, 4) dans des régions espacées sur le corps de matière piézoélectrique, pour détecter une tension produite par la matière piézoélectrique sous l'effet de la force produisant une tension, caractérisée en ce que le corps (2) de matière piézoélectrique fait fonction d'élément de support de la structure de sonde en supportant la pointe de sonde (6).

2. Une sonde selon le revendication 1, dans laquelle le corps (2) a un profil pratiquement en forme de L.

3. Une sonde selon la revendication 1, dans laquelle les moyens établissant un chemin conducteur de l'électricité (5) comprennent du métal déposé.

4. Une sonde selon la revendication 3, dans laquelle les moyens établissant un chemin conducteur de l'électricité (5) comprennent également un fil discret.

5. Une sonde selon la revendication 1, dans laquelle la première paire de connexions électriques (3, 4) dans des régions espacées consiste en une première paire de zones en métal déposé qui se trouvent sur des surfaces opposées du corps (2).

6. Une sonde selon la revendication 1, comprenant en outre une seconde paire de connexions électriques (11) consistant en une seconde paire de zones de métal déposé qui se trouvent sur des surfaces opposées du corps (2) et qui sont intercalées entre les moyens établissant un chemin conducteur de l'électricité (5) et la première paire de connexions de détection de tension (3, 4).

7. Une sonde selon la revendication 1, dans laquelle la pointe de sonde (6) est élastique et fait saillie au-delà du corps (2).

Fig. 1

Fig. 2

Fig. 3